# EUROPEAN PATENT SPECIFICATION

(11) **EP 0 279 535 B1**
(45) Date of publication and mention of the grant of the patent: **14.07.1993**
(21) Application number: 88300683.5
(22) Date of filing: 27.01.1988
(51) Int. Cl.: G11B 5/39, G01R 33/06

(54) **Head comprising a magnetoresistive sensor**
Kopf mit einem magnetoresistiven Aufnehmer
Tête compressant un détecteur magnétorésistif

(30) Priority: 17.02.1987 US 15200
(43) Date of publication of application: 24.08.1988
(73) Proprietor: SEAGATE TECHNOLOGY INTERNATIONAL, Georgetown, Grand Cayman Island (KY)
(72) Inventor: Mowry, Greg Stephen, Burnsville Minnesota 55337 (US)
(74) Representative: Kenyon, Sarah Elizabeth

(56) References cited:
- EP-A- 0 100 841
- GB-A- 2 054 940
- GB-A- 2 109 992
- GB-A- 2 146 482
- US-A- 3 953 888
- US-A- 4 103 315
- PATENT ABSTRACTS OF JAPAN, vol. 11, no. 22 (P-538)(2469), 21 January 1987& JP-A-61194620
- JOURNAL OF PHYSICS E-SCIENTIFIC INSTRUMENTS, vol. 19, no. 7, July 1986, pages 502-515, Bristol, GB; W. KNWIATKOWSKI et al.: "The permalloy magnetoresistive sensors-properties and applications"

## Description

This invention relates to a magnetoresistive head comprising a magnetoresistive sensor, for example, for magnetic disk drives.

Magnetoresistive sensors, which are responsive to change in resistivity caused by the presence of magnetic fields, are increasingly employed as read transducers in heads of magnetic disk drives primarily because the change of resistivity is independent of disk speed, depending only on the magnetic flux, and secondarily because sensor outputs may be scaled by sense current.

Magnetoresistive sensors typically comprise a thin strip of NiFe alloy (Permalloy) magnetised along an easy axis of low coercivity. Many other ferromagnetic alloys are also candidates. The magnetoresistive sensor is usually mounted in a head such that the easy axis is transverse to the direction of rotation of a disk and parallel to the plane of the disk. The magnetic flux from the disk causes rotation of the magnetisation vector of the magnetoresistive sensor which, in turn, causes a change in resistivity to a sense current flowing between lateral contacts. The resistivity varies approximately according to the cosine-square of the angle between the magnetisation vector and the current vector, i.e.:

$\text{Δρ = ρmax x cos²ϑ}$

where ϑ is the angle between the magnetisation and current vectors and
ρ is the resistivity.
Due to this cosine-square relationship, if the magnetisation and current vectors are initially aligned, the initial change in resistivity due to disk magnetic flux is low and unidirectional. Typically, therefore, either the easy axis magnetisation vector or the current vector is biased to approximately 45° to increase responsiveness to angular change in the magnetisation vector and to linearise the output of the magnetoresistive sensor.

A first problem encountered with magnetoresistive sensors is Barkhausen noise caused by the irreversible motion of magnetic domains in the presence of an applied field, i.e. coherent rotation of the magnetisation vector is non-uniform and suppressed, and depends upon domain wall behaviour. This noise mechanism is eliminated by creating a single magnetic domain in a sense current region of the magnetoresistive sensor.

Many different means have been employed both to linearise the output of the magnetoresistive sensor and to provide for a single domain in the sense current region.

One known solution, to cause a single domain in the sense current region for example, is to increase the length of a magnetoresistive sensor relative to its height. Multiple closure domains are known to occur at the ends of long magnetoresistive sensors. These migrate towards the centre under the influence of external fields. However, long magnetoresistive sensors may be subject to cross talk in lateral port ions thereof and may conduct magnetic flux from adjacent tracks to the sense current region of the magnetoresistive sensor. Short magnetoresistive sensors, in contrast, almost invariably spontaneously "fracture" into multiple domains.

Another known solution of providing single domains in the sense current region is by shaping the magnetoresistive sensor so as to reduce edge demagnetising fields while producing a relatively short physical dimension in the sense current region (see e.g. Figure 4a of US-A-4,503,394 where upper and lower horizontal sections with opposed easy axes are connected at the ends with vertical sections to comprise an endless loop). See also US-A-4,555,740 in which a magnetoresistive sensor has two intermediate, upwardly extending legs. However, such shaped magnetoresistive sensors suffer from a second problem in that sensors "fracture" into multiple domains in the presence of strong transverse magnetic fields. Strong transverse magnetic fields are caused by the inductive write poles between which the magnetoresistive sensors are conventionally mounted (the poles act as soft magnetic shields to isolate the magnetoresistive sensor from magnetic fields not directly adjacent thereto).

A third known solution of forming single domains by providing a longitudinal magnetic field in "long" or shaped magnetoresistive sensors, prior to reading. Such a magnetic field has to be strong enough to cause the formation of a relatively stable, single domain in the central sense current region. This initialisation field is generally provided by a barber pole, which also has the advantage that it can be used to cant the direction of the sense current relative to the easy axis magnetic vector.

A fourth known solution, particularly for short magnetoresistive sensors, is to maintain single domains by permanent longitudinal biasing from adjacent permanent magnets or atomically coupled antiferromagnetic material which results in exchange-biasing. Such biasing is also provided, in some applications, to transverse-bias the magnetic vector away from the easy axis to linearise the output of the magnetoresistive sensor, as mentioned above.

However, both of these biasing schemes (initialisation and permanent) have the drawback in that the biasing magnetic field could adversely affect the information pre-recorded on the magnetic disk, and further, a permanent biasing field (both transverse and longitudinal) increases the effective anisotropy of the magnetoresistive sensor thereby decreasing sensitivity to disk magnetic flux. The barber pole (canted current) design has the additional disadvantage that the effective length of the magnetoresistive sensor area is less than the longitudinal distance between canted contacts of the magnetoresistive sensor. The barber pole design also requires precise lithographic processes to apply the canted contacts and shortening stripes.

Exchange-biasing is not commonly used in practice because of the presence of two dissimilar materials (the magnetoresistive material and the antiferromagnetic material) at an exposed interface. This can lead to corrosion which can destroy a head. Further, because exchange-biasing is a quantum-mechanical interaction effect, reliable atomic interaction is imperative, but such processing is difficult and yields are low. Further, the effect has a strong temperature dependence, being substantially reduced in the typical operating environments of the conventional disk drives.

Hence, of all the known solutions to date none can minimise the noise yet provide a single domain without suffering from the problems of biasing, either initialisation or permanent.

A magnetoresistive sensor is disclosed in GB-A-2054940 but does not satisfactorily meet all of the aforementioned requirements.

Accordingly, an aim of the present invention is to provide a magnetoresistive head whose sensor does not suffer from Barkhausen noise yet may be mounted between the poles of a magnetoresistive head whilst obviating the disadvantages found with such sensors as discussed above.

According to one aspect of the present invention there is provided a magnetoresistive head comprising:
a magnetoresistive sensor for reading a magnetic recording medium having a plurality of magnetisation transitions recorded thereon, said sensor including a central sense region with a magnetisation vector and said sensor is disposed adjacent said recording medium for generating flux pulses in said sense region on passing by a magnetisation transition recorded on said magnetic medium;
means for providing a sense current in the sense region having a vector, characterised in that
said magnetisation vector is aligned parallel to the easy axis in the absence of any external magnetic fields from said recording medium; in that
said vector is aligned substantially parallel to said magnetisation vector; and in that
the magnetisation vector rotates away from the sense current vector in response to the flux of the recording medium to be sensed so that the angle between them is in the range of 40 to 50 degrees;
thereby enabling the sensor to operate in a non-linear mode because of the initial alignment of sense current and magnetisation vectors in the absence of magnetic flux from the magnetic medium, whilst enabling the sensor's response in the region of the flux pulse peak to be approximately a linear function of magnetic flux of the transition.

The sensor may have a pair of lateral extensions and two electrical contacts one each electrically contacting said extensions and having uncanted surfaces adjacent the central sense region, said surfaces being parallel to each other.

The sensor may have a pseudo-ellipsoidal shape. The shape preferably includes a flattened central sense current region and lateral, pointed ends.

The sensor may include exchange-biasing material atomically coupled to said extensions but not the central sense region.

The sensor may have an edge, said exchange-biasing material being spaced a short distance from the edge.

The electrical contacts may contact a respective one of the lateral, pointed ends.

Preferably the sensor is mounted in a magnetic head comprising a pair of inductive write poles and a soft-magnetic shield forming two gaps, a first gap between the poles, a second gap between a trailing one of said poles and said shield, the sensor being mounted in said second gap, a leading one of said poles having a length defining a track width, the central sense current region being approximately the same length as the leading pole, and the trailing pole having a length at least as long as the sensor. The soft magnetic shield may be at least as long as the sensor.

The sensor may include a voltage sensing circuit connected between each of said contacts.

It is noted that EP-0 279 536 relates to a head comprising a magnetoresistive sensor manufactured in thin film technique and that EP-A-0 279 537 relates to a magnetoresistive sensor. Both publications are of the same Applicant.

The invention is illustrated, merely by way of example, in the accompanying drawings, in which:-
Figure 1 is an elevation of a pseudo-ellipsoidal magnetoresistive sensor according to the present invention;
Figure 2 is an elongated magnetoresistive sensor according to the present invention invention having upwardly projecting ends with exchange-biasing material;
Figure 3 illustrates the essential steps for depositing exchange-biasing only on the ends of a magnetoresistive sensor according to the present invention;
Figure 4 is a magnetoresistive sensor of Figure 1 having exchange-biasing material at the ends;
Figure 5 is a cross section of a magnetoresistive head having a magnetoresistive sensor according to the present invention with recessed exchange-biasing material;
Figure 6 shows a layer structure of a double-gap magnetoresistive head with a magnetoresistive sensor according to the present invention;
Figure 7 is an elevational view of the essential elements for a double-gap magnetoresistive head with a magnetoresistive sensor according to the present invention;
Figure 8 shows a known magnetoresistive sensor with canted current contacts and electrical circuits connected thereto;
Figure 9 shows an easy axis pattern-biased magnetoresistive sensor according to the present invention and relaxed canted current contacts;
Figure 10 shows an easy axis pattern-biased pseudo-ellipsoidal magnetoresistive sensor according to the present invention;
Figure 11 shows the relative response of a magnetoresistive sensor according to the present invention in linear and non-liner modes; and
Figure 12 is a pseudo-ellipsoidal magnetoresistive sensor according to the present invention having uncanted contacts for a non-linear response.

In the drawings, like parts have been designated by the same reference numerals.

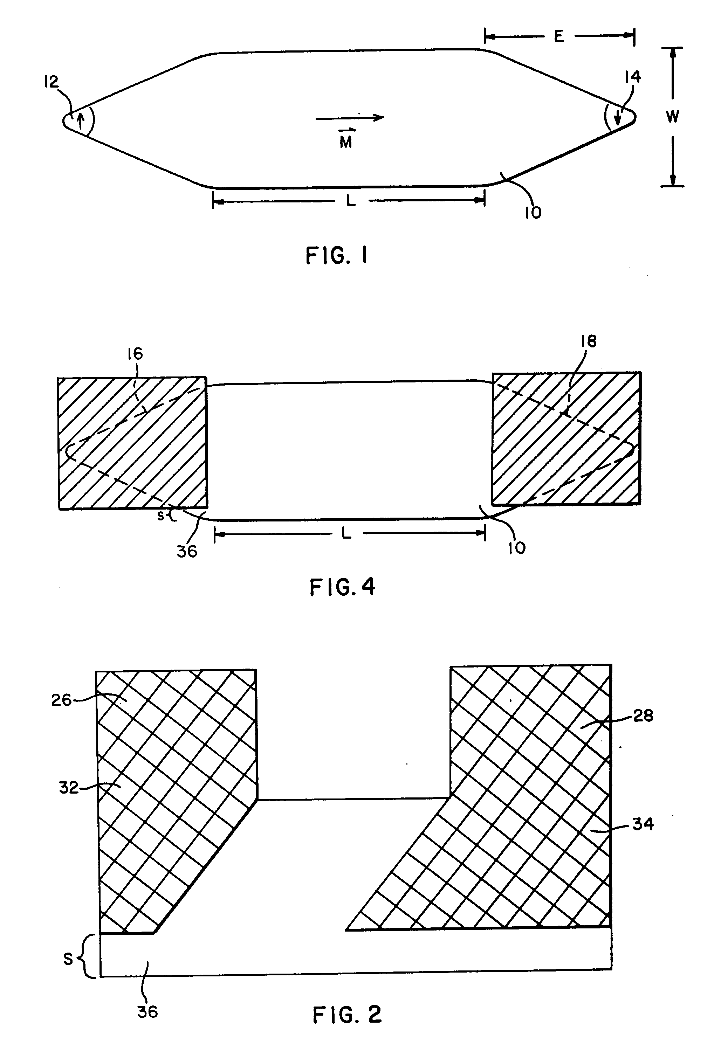

Figure 1 in this elevational view shows a pseudo-ellipsoidal magnetoresistive sensor 10 magnetised along the easy axis M. A central sense region L has relatively flat sides, rather than curved as in a true ellipse. The aspect ratio, AR, of overall length to height is less than 3, but can be greater with no loss of effect. From the central region L, the sides converge to apexes in which small magnetic domains 12,14 spontaneously form. Preferably W ≦ L and E (the length of an apex) is of the order of L at a minimum, having no known maximum. The structure forms a very stable central region single domain indicated by the large rightwardly directed arrow.

Experimentation with this structure shows that a thin layer of 200-500 angstroms Ni: 82Fe: 18 alloy, with an overall length of 25 microns, a central region L of 9 microns, and a width W of 8 microns requires 35 Oe to switch the magnetisation vector of the central region to the hard axis, while only 0.75 Oe is required in an unpatterned bulk film. This translates to a factor of 46 improvement.

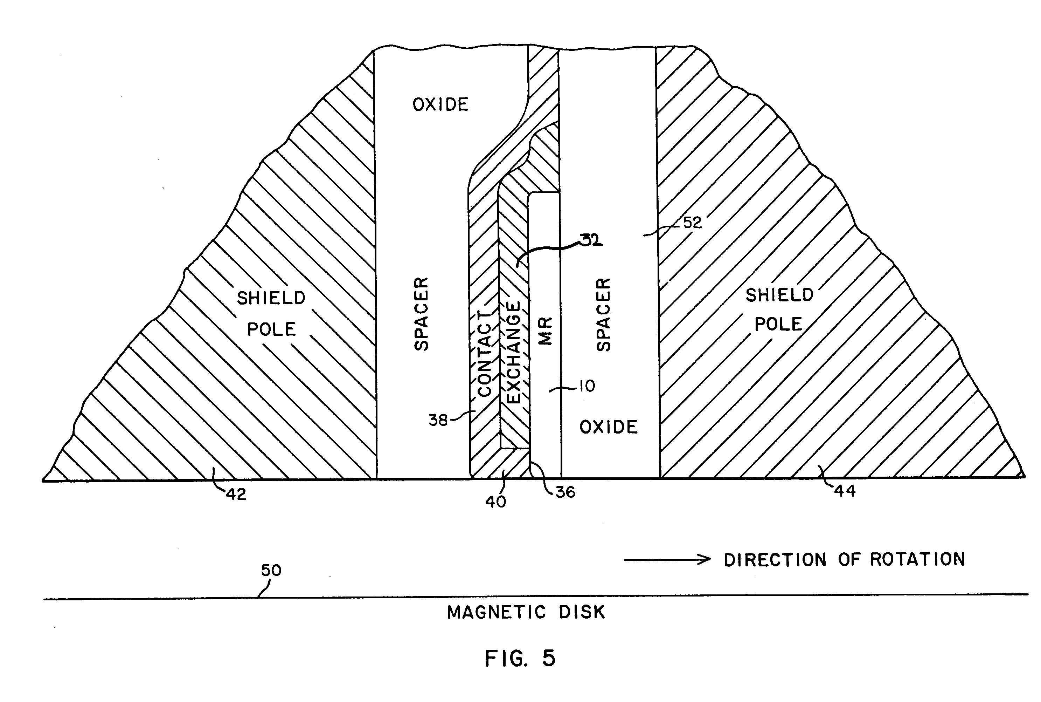

Where high transverse fields can be expected, such as when an unshielded magnetoresistive sensor is placed between or next to the poles of an inductive write head, longitudinal biasing is still required to initialise or maintain a single domain state. As hitherto discussed, there are many different means for accomplishing this. For example, barber pole biasing generates a longitudinal field. In addition permanent magnetic biasing or exchange-biasing can also provide a longitudinal field. A novel stabilisation means is disclosed in Figure 4.

Prior exchange stabilisation/biasing techniques have been typically prepared by first depositing a ferromagnetic layer upon a substrate and then depositing an antiferromagnetic layer upon the ferromagnetic layer such that, after patterning, the two layers coincide.

Exchange-biasing can result in a signal loss due to shunting effects. Longitudinal exchange fields have a negative temperature dependence. Finally, the possibility exists of corrosion due to bimetallic film structure.

The domain stabilisation process can be understood by recognising that if the magnetisation is pinned at the boundaries of a thin film strip then the equilibrium magnetisation direction can be controlled in the central region between the boundaries. By depositing FeMn in crosshatched regions 16,18 shown in Figure 4, the previously indicated drawbacks to standard exchange-biasing techniques can be avoided. First, since there is no exchange bias material in the central region L, there can be no signal loss due to current shunting. Secondly, this stabilisation technique is extremely temperature insensitive since the requirement is made that only the direction of the magnetisation be fixed: not the magnitude of the longitudinal exchange field. Finally, by proper patterning, the bimetallic interface can be eliminated at any exposed edge. Preferably the exchange bias material used is FeMn because of its electrical conductivity.

An embodiment of the magnetoresistive sensor having a stable single domain central region employing exchange-biased ends is shown in Figure 2. Here, the magnetised alloy strip has a C-shape with a relatively narrow central region and with the lateral ends having upwardly extending legs 26,28 for conducting the demagnetising field further away from the central region. This improves the stability of the single domain in the central region. Exchange-bias material 32,34 and contact metallisation (not shown) are applied to these ends which generally conforms to the pattern of canted current end contacts (not shown). This pattern of exchange-bias material eliminates edge and end domains and provides a stable central single domain sense current region. To avoid the aforementioned corrosion problem at exposed interfaces, a recess 36 with a width S is provided between the exchange-bias material and a lower edge of the magnetoresistive sensor 10, the lower edge being that exposed to the magnetic disk in most designs.

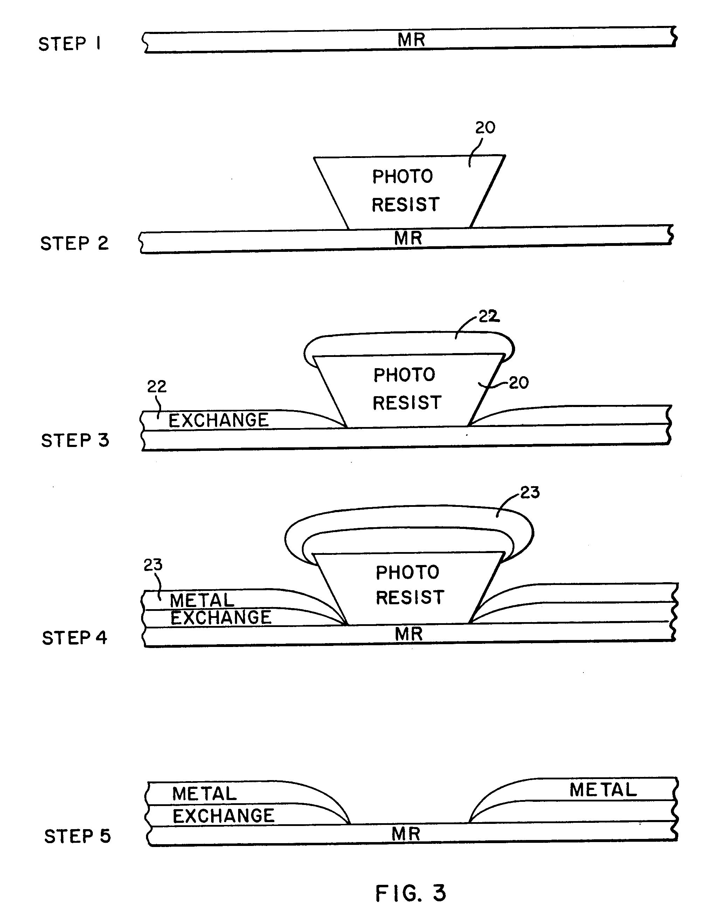

The process for forming the structure shown in Figure 2 is shown in Figure 3. Step 1: a strip of magnetoresistive material Mr is evaporated, sputtered or the like on a substrate (not shown for the purpose of clarity), in a uniform magnetic field directed along an easy axis, and patterned. Step 2: a photo resist layer 20 is laid down and patterned using conventional processes to form an island with inwardly inclined sides. Step 3: exchange-bias-material 22 is evaporated, sputtered or the like onto the magnetoresistive material Mr and the photo resist layer 20. Step 4: contact metallisation 23 is deposited. Step 5: using a lift-off process, the photo resist layer 20 with the exchange-bias material 22 and metallisation 23 thereon are removed.

The pseudo-ellipsoidal magnetoresistive sensor with exchange-bias material on its ends extending to a flattened central region L as shown in figure 4 is also formed by the process of figure 3.

Figure 5 shows a vertical cross-section of the exchange-biased magnetoresistive sensor 10 of either figure 2 or figure 4 mounted between shields 42,44 above a magnetic disk 50. The exchange-bias material 32 is recessed a short distance above a lower surface of the magnetoresistive element adjacent to the magnetic disk 50 to form the recess 36 and contact metal 38 has a leg 40 extending to the lower edge of the magnetoresistive sensor 10 to shield the exchange-bias material 32 from exposure. At least one of the shields 42,44 also comprises one of the poles of an inductive write apparatus (not shown). The shields are separated via spacers 52 typically composed of a non-magnetic material such as AL₂O₃. By providing the recess 36, the contact material 38 has the leg 40 directly contacting the lower surface of the magnetoresistive sensor 10. This shields the exchange-bias material 32 from exposure. Most heads land on the surface of the magnetic disk 50 when disk rotation stops, burnishing small amounts of the head material away. The amount of the recess 36 versus the degree of burnishing determines the lifetime of the head until the exchange-bias material is exposed leading to potential corrosion.

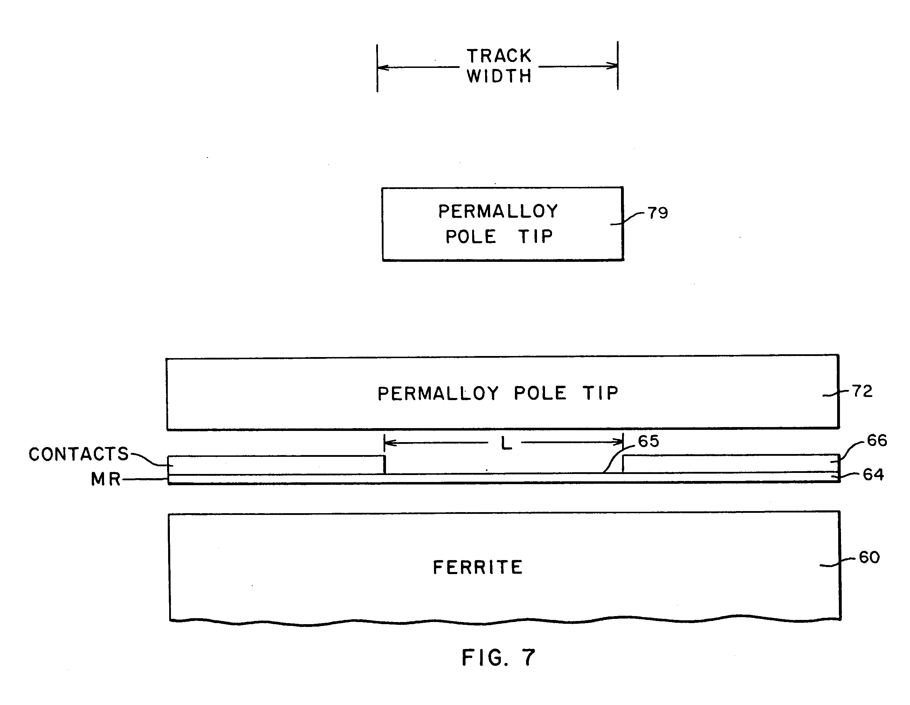

The existence of strong transverse magnetic fields causes relatively stable single domain regions to "fracture" into multiple domains, the source of Barkhausen noise. Strong magnetic fields are present between pole tips of the inductive write apparatus, the conventional location of most magnetoresistive sensors. To reduce the effect of the inductive write pole tips on the magnetoresistive sensor, it is known to place it along side the pole tips (see US-A-4,321,641). This type of structure requires a soft magnetic shield, a shield/trailing pole tip, and a leading pole tip. The design of US-A-4,321,641 is not entirely satisfactory, primarily due to the extension of magnetoresistive material (see Figure 4 or Figure 7) beyond a shield of a trailing pole tip.

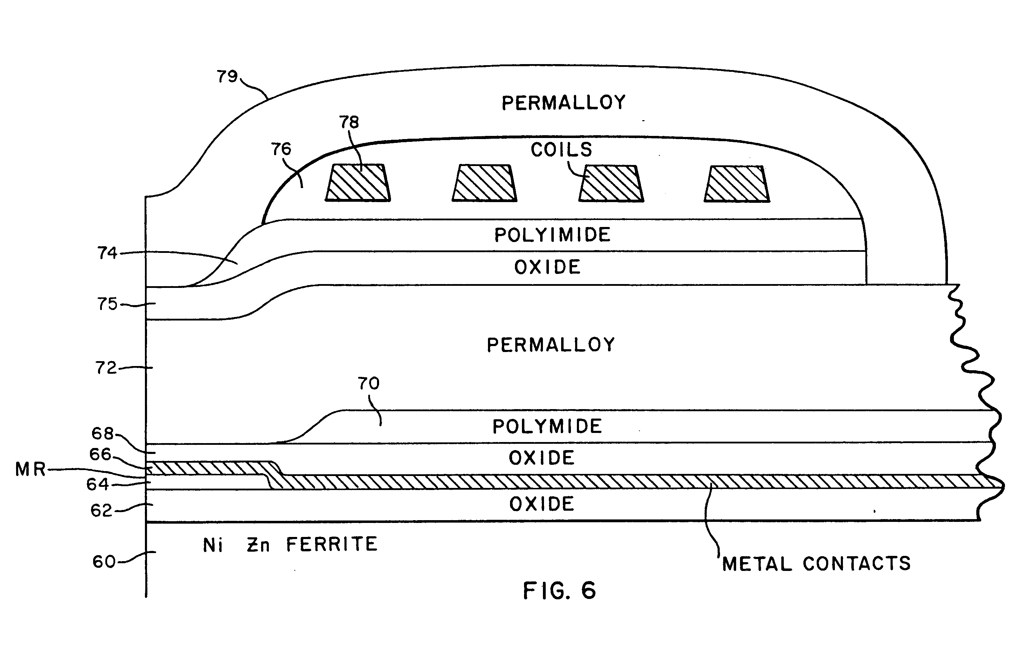

The magnetoresistive head shown in Figures 6 and 7 hereof provides a very magnetically quiet region for the magnetoresistive sensor. The residual flux from the magnetic poles of the inductive write apparatus is so low as to permit the reliable operation of very stable, shaped, single domain sensors (e.g. the pseudo-ellipse magnetoresistive sensor 10 of Figure 1) without longitudinal biasing.

Figure 6 is a cross-section of the essential elements of a magnetoresistive sensor. A layer 62 of oxide, preferably aluminium oxide, is deposited upon a soft magnetic substrate 60, preferably NiZn. Next, magnetoresistive sensor material 64 is deposited in a magnetic field and patterned. Exchange-bias material may then be deposited and patterned if desired. Metal contacts 66 are then deposited on the magnetoresistive sensor material 64. A second layer of oxide 68 is then deposited. The two oxide layers 62,68 comprise a read gap. A layer of polyimide or photo resist 70 is then deposited and patterned as shown to remove the layer adjacent a gap end of the magnetoresistive head. Next a layer 72 of ferromagnetic material is laid down, preferably of NiFe (Permalloy). This layer 72 comprises a trailing pole/shield. Next, a write gap oxide layer 75 of, for example, aluminium oxide or silicon dioxide, is deposited followed by a second layer 74 of polyimide or photo resist. Metal coils 78 are deposited and patterned. Two layers 76 of polyimide or photo resist are deposited and patterned to remove the portion not adjacent the coils 78. Finally, a final layer 79 of a ferromagnetic material comprises the leading pole/shield and is deposited to encompass the coils and contact the layer 72 to form a continuous flux path. After the magnetoresistive sensor is formed, it is typically sealed in a suitable non-magnetic material and the gap end processed, e.g. by lapping to expose the end gap or gaps and providing a reliable gap height.

Figure 7 is an end view of the essential elements of a magnetoresistive sensor. Spacing layers are omitted for clarity. Shown in the Figure are the substrate 60, the magnetoresistive sensor material 64, its lateral metal contact 66 defining a central senser current region 65 of length L, and the ferromagnetic trailing pole/shield 72, and the leading pole/shield 79. The length of the leading pole/shield 79 defines the written track width via magnetic mirroring with the trailing pole/shield 72. This length corresponds to the length L (plus a processing guard band wherein the length L is intentionally made smaller than the written track width to avoid possible cross talk) of the central senser current region 65 of the magnetoresistive sensor material 64. Typically, the magnetoresistive sensor material is longer than a track width to assist in providing a stable single domain in the central senser current region 65. It is essential that the trailing pole/shield 72 is as long as the magnetoresistive sensor material 64 to shield it completely from side fringing fields originating during the writing process. This makes the leading and trailing poles/shields 79,72 of different lengths. However, it has been discovered that this does not affect the written track width, which is defined by the length of the leading pole/shield 79 and the above mentioned mirroring effects.

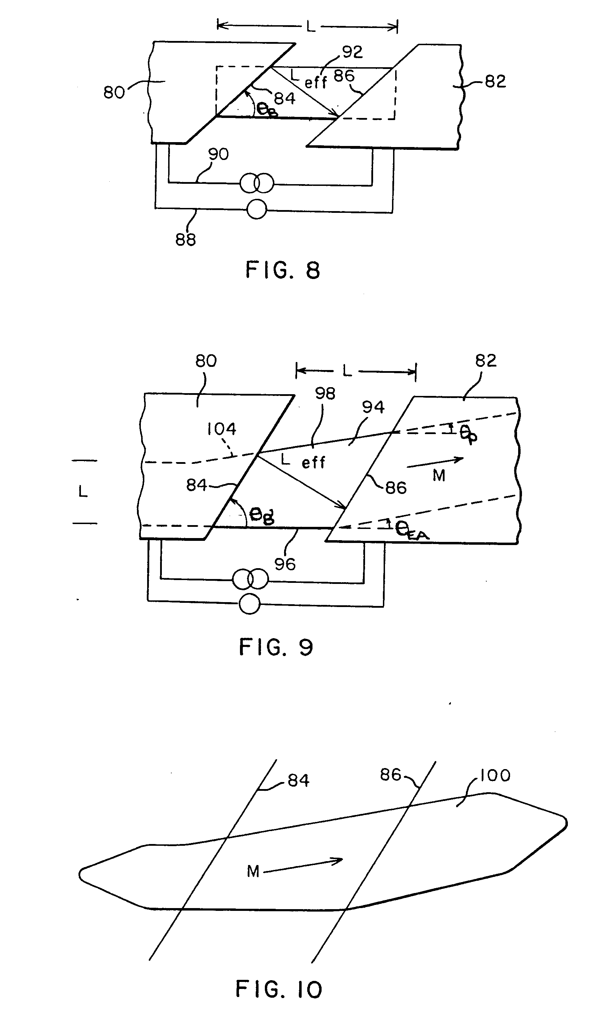

For many applications, such as audio applications, linear operation of a magnetoresistive sensor is desirable. As mentioned above, linearisation either requires the canting of the easy axis magnetisation vector or the canting of the current vector. Canting of the magnetisation vector typically increases anisotropy and reduces the range of resistivity change and thus sensitivity of the magnetoresistive sensor. Canting the current likewise causes a comparable loss in sensitivity as better illustrated in Figure 8.

Figure 8 shows a typical canted current biasing technique wherein conductors 80,82, intimately contacting a magnetoresistive strip 92 of length L provide a canted current from a source 88 generally in the direction L_{eff} between the contacts. The current direction is generally perpendicular to the surfaces 84,86 of the conductors. These surfaces are generally canted at an angle of ϑ_{B} of between 40° and 45° for greatest linearity and sensitivity. The change in resistivity is sensed by means 90 (which can be a voltage sensor if the source 88 is a constant current source, a transimpedance current sensor if the source 88 is a constant voltage source, or a power sensor if the source 88 is a "soft" source). The change in resistivity is generally proportional to the length L_{eff} which is less than the length L between the conductors in the longitudinal direction. The length L, in turn, is approximately the track width of one track and defines the length of the sense current region. Thus, the sensitivity of the magnetoresistive sensor is reduced by the ratio L_{eff}/L. Making L_{eff} comparable to track width is not desirable because the length L would then be long enough to pick up significant cross talk from adjacent tracks.

Figure 9 shows an improved canted magnetoresistive sensor 94 according to the present invention which relaxes the cant of the surfaces 84,86 of the contacts 80,82 to an angle ϑ_{Bʹ} of approximately 50°. This substantially increases L_{eff} and thereby sensitivity while maintaining the approximately 40° to 45° angle with the easy axis. The reason for this is that the magnetoresistive sensor is patterned such that its easy axis is itself canted by an angle ϑ_{EA} of approximately 10°.

The surfaces 84,86 are each canted at an angle ϑ_{Bʹ} which is preferably 50°. A lower edge 96 of the magnetoresistive sensor is parallel to the magnetic disk surface as in the prior art but an upper edge 98 is patterned at an angle of ϑ_{P} thereto to give a resultant easy axis magnetisation vector M at an angle ϑ_{EA} of approximately 10° to the lower edge 96.

The magnetoresistive sensor 94 is formed from a bulk film deposited on a suitable substrate in an uniform magnetic field directed parallel to the lower edge 96. The bulk film is thereafter patterned using conventional lithographic techniques to form the pattern illustrated with the upper edge 98 forming an upwardly extending angle with the lower edge 96. This shape inherently cants the easy axis magnetisation vector M upwards, though to a lesser degree than the angle of the upper edge 98. To achieve the net easy axis rotation of 10° it will be appreciated that the strength of the undeflected easy axis vector with the size, length, thickness, and composition of the magnetoresistive material with the angle of the upper edge to the lower edge will have to be balanced.

In this embodiment, the magnetoresistive sensor 94 is composed of 80:20 NiFe alloy, approximately 500 angstroms thick, with L approximately equal to 9 microns, h (the height of the magnetoresistive sensor at a point 104) approximately equal to 8 microns, and ϑ_{P} is 10°, ϑ_{Bʹ} is 50° and ϑ_{EA} is 10°. Figure 10 shows an example of a canted easy axis psuedo-ellipsoidal magnetoresistive sensor 100 and its relative orientation with surfaces 84,86 (the conductors 80,82 are not shown in Figure 10).

For most digital applications, data is written on the disk in code (e.g. variable length 2,7) where only the location of a transition (pulse peak) rather than its direction and magnitude is important. Pulse amplitude serves the function of triggering qualifiers to discern between signal and noise. Thus exception for improved initial sensitivity to magnetisation vector rotation, there is no good reason to operate the magnetoresistive sensor linearly. Thus the final improvements to the magnetoresistive sensor are to provide no transverse biasing at all, except perhaps the patterned-biasing just described, operate the magnetoresistive sensor in a non-linear mode and design the magnetoresistive sensor and disk flux such that the magnetisation vector rotation in response to disk flux is of the order of 40° to 50°.

Because the location of a transition (pulse peak) is important, the signal from the disk is conventionally differentiated and the zero crossing detected. Noise makes the location of the zero crossing uncertain, and for this reason, noise ultimately limits the data density. However, by not biasing the magnetoresistive sensor, it will operate in its non-linear mode and the differential will have a steeper zero crossing slope than that of a linearly biased magnetoresistive sensor. This increased zero crossing slope leads to less sensitivity to noise, and to a more accurate detection of zero crossing locations, all other things being equal.

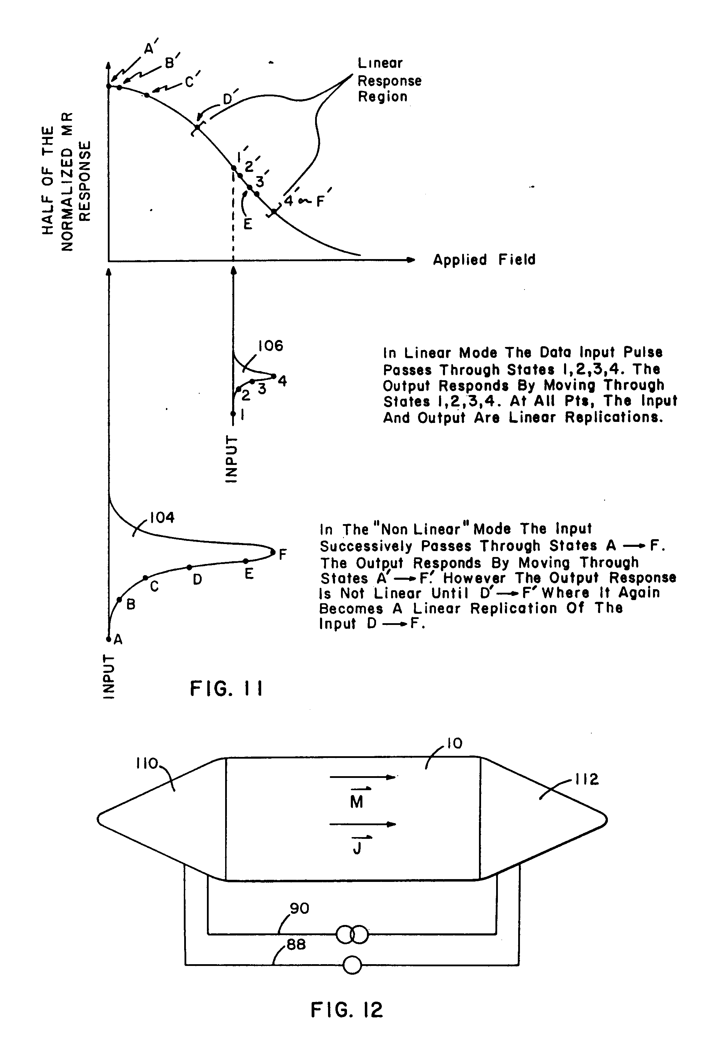

In order to achieve a proper non-linear signal out of the magnetoresistive sensor, the magnetisation vector must be made to rotate to a greater degree than in the biased case (see Figure 11 for an illustration of the principle). The upper portion of Figure 11 shows graphically half the normalised magnetoresistive response. The lower portion of Figure 11 shows graphically two disk flux input signals 104,106, the signal 104 representing the input signal to a non-linear magnetoresistive sensor, and the signal 106 representing the input to a linear magnetoresistive sensor. While the two signals 104,106 are shown with greatly different magnitudes, they may actually be of the same magnitude if the relative response of the magnetoresistive sensor is proportional to the relative difference shown. Actually, it may be preferable to adjust the relative response of both the disk and the magnetoresistive sensor.

In a linear mode of operation, the signal 106 passes through states 1, 2, 3 and 4 and the magnetoresistive sensor responds by moving through resistivity states 1ʹ, 2ʹ, 3ʹ and 4ʹ (for an oppositely polarised pulse, the states would be on the opposite side of the state 1ʹ). For all states, the inputs and outputs are linear replications.

In a non-linear mode, the signal 104 passes through states A to F and the sensor responds with states Aʹ to Fʹ (an oppositely polarised signal pulse would result in the same output, but from the other half of the resistivity curve). The output is non-linear until region Dʹ to Fʹ, where it again becomes a linear replication.

It can be seen from Figure 11 that the total response of the non-linear magnetoresistive sensor (from Aʹ to Fʹ) is greater than the total response from the linear magnetoresistive sensor (from 1ʹ to 4ʹ). Thus total sensitivity is greater, and transition centres (pulse peaks) can be more accurately located. Actual output of the magnetoresistive sensor is increased by 25 to 30%.

While there are many possible choices of materials to achieve the response indicated in Figure 11, the preferred choice is a magnetoresistive sensor comprised of permalloy and a magnetic disk material with sufficient flux to yield the magnetisation vector rotation indicated with a magnetoresistive sensor mounted on a conventional head.

Figure 12 shows a magnetoresistive sensor 10 of psuedo-ellipsoidal shape with contacts 84,86, a constant current source 88 and a voltage sensor 90. This magnetoresistive sensor is preferably mounted in the double gap head of Figures 6 and 7. By providing no biasing whatsoever, the sensor operates in a non-linear mode. Its shape and location in the shielded second gap of the double gap head maintains the magnetoresistive sensor in a single domain state. If this implementation is not robust enough for a given application, then stability can be further enhanced by providing exchange material in regions 110,112 as previously described.

It will be appreciated that, as in Figure 9, the other illustrated embodiments of the present invention have the easy magnetisation axis canted upwardly from a line parallel to a lower edge of the magnetoresistive sensor.

## Claims

1. A magnetoresistive head comprising:
a magnetoresistive sensor (10; 64; 94; 100) for reading a magnetic recording medium (50), having a plurality of magnetisation transitions recorded thereon, said sensor including a central sense region (L) with a magnetisation vector (M) and said sensor is disposed adjacent said recording medium for generating flux pulses in said sense region on passing by a magnetisation transition recorded on said magnetic medium;
means (88) for providing a sense current in the sense region (L) having a vector (J), characterised in that
said magnetisation vector (M) is aligned parallel to the easy axis in the absence of any external magnetic fields from said recording medium; in that
said vector (J) is aligned substantially parallel to said magnetisation vector (M); and in that
the magnetisation vector rotates away from the sense current vector in response to the flux of the recording medium to be sensed so that the angle between them is in the range of 40 to 50 degrees;
thereby enabling the sensor to operate in a non-linear mode because of the initial alignment of sense current and magnetisation vectors in the absence of magnetic flux from the magnetic medium, whilst enabling the sensor's response in the region of the flux pulse peak to be approximately a linear function of magnetic flux of the transition.

2. A head as claimed in claim 1, in which said sensor further comprises a pair of lateral extensions (12,14; 26,28;) and two electrical contacts (38;66;80,82) one each electrically contacting said extensions to said sense current means and having uncanted surfaces adjacent the central sense region, said surfaces being parallel to each other.

3. A magnetoresistive head as claimed in claim 1 or 2 in which said sensor has a pseudo-ellipsoid shape.

4. A magnetoresistive head as claimed in claim 2 or 3 further comprising exchange-biasing material (16,18) atomically coupled to said extensions (12,14), but not to the central sense region (L).

5. A magnetoresistive head as claimed in claim 4 in which said sensor includes an edge (36), said exchange-biasing material being spaced a short distance from the edge.

6. A magnetoresistive head as claimed in any preceding claim further comprising a pair of inductive write poles (72,79) and a soft-magnetic shield (60) forming two gaps, a first gap between the poles, a second gap between a trailing one (72) of said poles and said shield (60), the sensor being mounted in said second gap, a leading one (79) of said poles having a length defining a track width, the central sense current region (L) being approximately the same length as the leading pole and the trailing pole having a length at least as long as the sensor.

7. A magnetoresistive head as claimed in claim 6 in which the soft-magnetic shield (60) is at least as long as the sensor.

8. A magnetoresistive head as claimed in any one of claims 2 to 7 further comprising a voltage sensing circuit (90) connected between each of said contacts.

## Patentansprüche

1. Magnetowiderstands-Kopf mit:
einem Magnetowiderstands-Sensor (10;64;94;100) zum Lesen eines magnetischen Aufzeichnungsmediums (50), auf dem eine Vielzahl von Magnetisierungsübergängen aufgezeichnet ist, wobei der Sensor einen in der Mitte liegenden Sensorbereich (L) mit einem Magnetisierungsvektor (M) einschließt und der Sensor benachbart zu dem Aufzeichungsmedium angeordnet ist, um Magnetflußimpulse in dem Sensorbereich beim Vorbeilaufen eines auf dem magnetischen Aufzeichnungsmedium aufgezeichneten Magnetisierungsüberganges zu erzeugen,
Einrichtungen (88) zur Lieferung eines Meßstromes in dem Sensorbereich (L) mit einem Vektor (J),
dadurch gekennzeichnet, daß
der Magnetisierungsvektor (M) bei Fehlen äußerer Magnetfelder von dem Aufzeichnungsmedium parallel zur Vorzugsmagnetisierungsachse ausgerichtet ist,
der Vektor (J) im wesentlichen parallel zu dem Magnetisierungsvektor (M) ausgerichtet ist, und
der Magnetisierungsvektor sich in Abhängigkeit von dem zu messenden Fluß des Aufzeichnungsmediums von dem Meßstromvektor fort dreht, so daß der Winkel zwischen diesen Vektoren im Bereich von 40° - 50° liegt,
sodaß der Sensor aufgrund der anfänglichen Ausrichtung der Meßstrom- und Magnetisierungsvektoren bei Fehlen eines magnetischen Flusses von dem magnetischen Aufzeichnungsmedium in einer nichtlinearen Betriebsweise arbeiten kann, während ermöglicht wird, daß das Ansprechverhalten des Sensors im Bereich der Magnetflußimpulsspitze angenähert eine lineare Funktion des magnetischen Flusses des Überganges ist.

2. Kopf nach Anspruch 1, bei dem der Sensor weiterhin zwei seitliche Verlängerungen (12,14;26,28) und zwei elektrische Kontakte (38;66;80,82) aufweist, die jeweils die Verlängerungen mit den Meßstromeinrichtungen elektrisch in Kontakt bringen und unverkantete Oberflächen benachbart zu dem in der Mitte liegenden Sensorbereich aufweisen, wobei die Oberflächen parallel zueinander verlaufen.

3. Magnetowiderstands-Kopf nach Anspruch 1 oder 2, bei dem der Sensor eine pseudo-elliptische Form aufweist.

4. Magnetowiderstands-Kopf nach Anspruch 2 oder 3, der weiterhin Austausch-Vormagnetisierungsmaterial (16,18) aufweist, das mit den Verlängerungen (12,14) atomgekoppelt ist, nicht jedoch mit dem in der Mitte liegenden Sensorbereich (L).

5. Magnetowiderstands-Kopf nach Anspruch 4, bei dem der Sensor eine Kante (36) aufweist, wobei das Austausch-Vormagnetisierungsmaterial gegenüber der Kante um eine kurze Strecke zurückversetzt ist.

6. Magnetowwiderstands-Kopf nach einem der vorhergehenden Ansprüche, der weiterhin zwei induktive Schreibpole (72,79) und eine weichmagnetische Abschirmung (60) zur Bildung zweier Spalte umfaßt, wobei ein erster Spalt zwischen den Polen und ein zweiter Spalt zwischen dem in Bewegungsrichtung hinteren (72) der Pole und der Abschirmung (60) liegt, wobei der Sensor in dem zweiten Spalt befestigt ist und ein in Bewegungsrichtung vorderer (79) der Pole eine Länge aufweist, die eine Spurweite festlegt, wobei der in der Mitte liegende Sensorbereich (L) angenähert die gleiche Länge wie der vordere Pol aufweist und der hintere Pol eine Länge aufweist, die zumindestens so groß ist, wie die des Sensors.

7. Magnetowiderstands-Kopf nach Anspruch 6, bei dem die weichmagnetische Abschirmung (60) zumindestens so lang wie der Sensor ist.

8. Magnetowiderstands-Kopf nach einem der Ansprüche 2 bis 7, der weiterhin eine Spannungsmeßschaltung (90) umfaßt, die zwischen jedem der Kontakte angeschaltet ist.

## Revendications

1. Tête magnétorésistante comprenant :
un détecteur magnétorésistant (10;64;94;100) destiné à lire un milieu d'enregistrement magnétique (50) sur lequel sont enregistrées une pluralité de transitions de magnétisation, ledit détecteur comprenant une région détectrice centrale (L) qui présente un vecteur de magnétisation (M), et ledit détecteur est disposé adjacent audit milieu d'enregistrement pour engendrer des impulsions de flux dans ladite région détectrice en réponse au passage d'une transition de magnétisation enregistrée sur ledit milieu magnétique ;
des moyens (88) destinés à engendrer dans la région détectrice (L) un courant de détection ayant un vecteur (J), caractérisée en ce que
ledit vecteur de magnétisation (M) est aligné parallèlement à l'axe direct en l'absence de champs magnétiques extérieurs issus dudit milieu d'enregistrement; en ce que
ledit vecteur (J) est aligné sensiblement parallèlement audit vecteur de magnétisation (M) ; et en ce que
le vecteur de magnétisation tourne en s'écartant du vecteur de courant de détection en réponse au flux du milieu d'enregistrement à détecter de telle manière que l'angle entre ces vecteurs soit dans l'intervalle de 40 à 50 degrés ;
en permettant ainsi au détecteur de travailler dans un mode non linéaire en raison de l'alignement initial des vecteurs du courant de détection et de magnétisation en l'absence de flux magnétique issu du milieu magnétique, tout en permettant à la réponse du détecteur dans la région du pic d'impulsion de flux d'être approximativement une fonction linéaire du flux magnétique de la transition.

2. Tête selon la revendication 1, dans laquelle ledit détecteur comprend deux prolongements latéraux (12,14;26,28) et deux contacts électriques (38;66;80;82), dont chacun met lesdits prolongements en contact électrique avec lesdits moyens de courant de détection et possède des surfaces non inclinées dans la région adjacente à la région de détection centrale, lesdites surfaces étant parallèles entre elles.

3. Tête magnétorésistante selon la revendication 1 ou 2, dans laquelle ledit détecteur possède une forme pseudo-ellipsoïdale.

4. Tête magnétorésistante selon la revendication 2 ou 3, comprenant en outre une matière d'échange-polarisation (16,18) couplée par une liaison atomique auxdits prolongements (12,14) mais non pas à la région de détection centrale (L).

5. Tête magnétorésistante selon la revendication 4, dans laquelle ledit détecteur présente un bord (36), ladite matière d'échange-polarisation étant espacée d'une petite distance de ce bord.

6. Tête magnétorésistante selon l'une quelconque des revendications précédentes, comprenant en outre deux pôles d'enregistrement inductifs (72,79) et un écran à magnétisme doux (60) formant deux entrefers, un premier entrefer entre les pôles, un second entrefer entre celui (72) desdits pôles qui est en position arrière et ledit écran (60), le détecteur étant monté dans ledit second entrefer, celui (79) desdits pôles qui est en position avant ayant une longueur qui définit une largeur de piste, la région (L) de courant de détection centrale étant approximativement de même longueur que le pôle avant, et le pôle arrière ayant une longueur au moins aussi grande que celle du détecteur.

7. Tête magnétorésistante selon la revendication 6, dans laquelle l'écran (60) à magnétisme doux est au moins aussi long que le détecteur.

8. Tête magnétorésistante selon une quelconque des revendications 2 à 7, comprenant en outre un circuit détecteur de tension (90) connecté entre lesdits contacts.
